# EUROPEAN PATENT APPLICATION

(11) **EP 0 731 503 A2**
(43) Date of publication of application: **11.09.1996**
(21) Application number: 95119559.3
(22) Date of filing: 12.12.1995
(51) Int. Cl.: H01L 21/768

(54) **Semiconductor cavity filling process**

(30) Priority: 12.12.1994 US 354590
(71) Applicant: TEXAS INSTRUMENTS INCORPORATED, Dallas Texas 75265 (US)
(72) Inventor: Dixit, Girish A., Plano, TX 75023 (US); Havemann, Robert H., Garland, TX 75044 (US)
(74) Representative: Schwepfinger, Karl-Heinz, Dipl.-Ing.

(57) **Abstract**

An improved process is provided which allows for enhanced filling of contacts, vias (600 and trenches (80) that are formed in dielectrics (62) of integrated circuits, particularly sub-0.5 µm technologies. In a preferred aspect of the invention, filling proceeds at a temperature of about 250 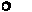 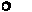 -450 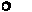 in a vacuum of about 10⁻⁶ - 10⁻⁸ TORR and a processing pressure of about 300 - 1,000 atmospheres. The process of the present invention is applicable for different metals and metal alloys, adjustments to the processing parameters being undertaken in accordance with the various chemical and physical properties of the material to be filled in the respective contacts, vias (60) or trenches (80).

## Description

### TECHNICAL FIELD OF THE INVENTION

This invention relates to semiconductor manufacturing processes, and more particularly to processes for gap filling between adjacent surfaces or levels of a semiconductor.

### BACKGROUND OF THE INVENTION

Many obstacles exist to further miniaturization of semiconductor components. Among these obstacles include the filling of metal interconnect layers to insure proper operation of the devices. Metal interconnect signal lines make contact to lower conductive layers of the integrated circuit through vias that are formed in an insulating layer. It is desirable to completely fill the via with the metal that is used to form the interconnect layer so as to insure optimal operation of the device.

For reasons of its cost, physical properties and availability, aluminum is presently the metal of choice for the fabrication of metal interconnect lines in integrated circuits. The interconnect lines are typically formed by a sputtering process, which can result in less than optimal filling of the contact vias. Problems arise from the accumulation of relatively large grains of aluminum at the upper surface of the insulating layer. The accumulation of such grains at the edges of the contact via can block or otherwise obstruct the via prior to passage of the aluminum in sufficient quantity to completely fill the via, resulting in the formation of voids and uneven structures within the via. This problem is particularly acute as integrated circuits are fabricated using smaller geometries. The smaller contacts that are used in smaller geometry devices, such as the current 0.5mm and future generations of scaled technologies, necessarily have a larger aspect ratio (i.e., relationship of height to width) than do larger geometry devices, thereby exacerbating the via filling difficulties described above. For example, unduly large voids can result in contact resistance that is appreciably higher than designed. In addition, thinner regions of the aluminum layer adjacent to the via fill region will be subject to eletromigration, which can result in the eventual opening of the circuits and failure of the device.

A number of different approaches have been attempted to ensure optimal metal contact at lower interconnect levels. For example, refractory metal layers have been used in conjunction with an aluminum interconnect layer to improve conduction throughout a via. In addition, via side walls have been sloped so as to improve metal step coverage into vias. The use of sloped side walls, however, has become less desirable as the industry adopts smaller device geometries. Even with the geometries above 0.5m, the foregoing techniques have not completely overcome the difficulties in the via filling. It is believed that the problem of via filling in the past has been at least partially attributable to the relatively low temperatures at which the aluminum was processed incident to via filling. These temperatures typically are below 500^{o}C which some manufacturers believe contributes to the formation of aluminum grain sizes that are unduly large for via filling.

U.S. Patent No. 5,108,951 to Chen, et al., which issued on April 28, 1992 attempts to address the foregoing problem of via filling arising from the flow of aluminum grains of unduly large size. In this patent, the temperature of the integrated circuit is heated to a temperature of about 400^{o}C prior to the commencement of aluminum deposition. Aluminum is deposited into the via during the course of wafer heating to a temperature of about 500^{o}C. Aluminum is deposited into the via at a rate of about 30-80 angstroms/sec during the course of wafer heating. This prior art system shares many of the same disadvantages of the previously addressed prior art, namely incomplete via filling, particularly at smaller via geometries. In addition, via filling is undertaken at temperatures in the vicinity of about 500^{o}C, prevents the use of polymeric materials as dielectrics in the integrated circuit, as these polymeric materials typically decompose at such high temperatures.

In view of the foregoing deficiencies in the prior art, it is desirable to provide an integrated circuit filling process for contacts and vias which provides for a reliable filling at relatively low temperatures, preferably on the order of about 250-450^{o}C. Contact and via filling at such low temperatures will permit for the use of more optimal dielectric materials which is critical to the development of sub-0.5mm technologies.

### SUMMARY OF THE INVENTION

As a consequence of the foregoing prior art deficiencies, it is desirable to provide a process for the filling of integrated circuit contacts and vias which is operable at relatively low temperatures of on the order of 250^{o}-450^{o}C, which temperature range will permit for the use of low dielectric constant polymers, the use of which has heretofore not been possible due to the high temperatures required in prior art via filling processes.

It would also be advantageous to utilize a relatively low temperature filling process that allows for filling with aluminum, aluminum alloys, copper and copper alloys. Contacts and vias to be filled with such metals can optionally be lined with physical vapor deposition ("PVD") or chemical vapor deposition ("CVD") refractory metals and/or metal alloys. The gaps can also be formed through various dielectrics or combinations of dielectrics.

In accordance with the present invention, an improved filling process is provided which allows for enhanced filling of contacts, vias and trenches formed in dielectrics of integrated circuits, particularly sub-0.5mm technologies. In a preferred aspect of the invention, filling proceeds in a temperature range of from about 250^{o}-450^{o}C in a vacuum of from about 10 ⁻⁶-10⁻⁸ Torr and a processing pressure of about 300 - 1000 atmospheres. Such processing is in sharp contrast to that of the prior art, which typically provides for processing at a mere fraction of an atmosphere, typically on the order of about 1-4mTorr at comparable vacuum levels, and temperatures typically in excess of 500^{o}C. The process of the present invention is applicable for different metals and metal alloys, adjustments to the processing parameters disclosed above being undertaken in accordance with the various physical and chemical properties of the material to be filled into the respective gaps, holes or trenches.

Suitable metals and metal alloys for use in the present invention include, by way of non-limiting example, the following materials: (1) Al - T (0.1%) - Cu(0.5%); (2) Al - Cu (0.5%); (3) Al - Cu (1%); (4) Al - Si (1%) - Cu (0.5%); and (5) Aluminum. In addition, the process of the present invention is suitable for use with refractory metals and metal alloys, such as, (1) pure copper (Cu); (2) alloys of copper with one or more of magnesium (Mg), gold (Au) and silver (Ag); and Al-Sc-Cu. The process of the invention is also applicable for use in the application of various refractory claddings and bassiers, such as those formed from titanium Ti, TiN, combinations of Ti and TiN, TiW, and tungsten (W).

The processing regimen of the present invention is particularly advantageous when processing integrated circuits with polymeric insulators, since such insulators typically decompose at temperatures of about 350^{o}C or greater. Such polymeric insulators include, by way of non-limiting example, the family of polytetrafluoroethylene ("PTFE") compounds, which exhibit a dielectric constant of 1.9 and are therefore very attractive because of their ability to reduce parasitic capacitance of interconnects.

The processing techniques of the present invention are also applicable to ensure complete filling of holes and/or trenches that are formed through various dielectic materials or combinations of dielectic materials . As such, the process techniques of the present invention are applicable for the family of damascene and dual damascene processing techniques, in which a groove is etched or otherwise formed in an oxide or other dielectric, then filled with a metal (usually tunsten or copper) in an appropriate deposition process such as chemical vapor deposition ("CVD"), after which the applied metal is polished so as to be flush to the surface of the dielectric. In the dual damascene process, not only is a groove etched or otherwise formed in the dielectric, but in addition thereto a via is patterned and etched so as to extend from an upper level of metal through a dielectric to a lower level of metal. Suitable dielectrics for use in the present invention include the family of polymeric spin-on-glass ("SOG") materials, such as the 1500 Series manufactured by Allied Signal Corp.; the family of PTFE; parylene; polyimides; hydrogen silsesquioxane; aerogels and surface modified aerogels such as fluorinated and methylated aerogels, all of which are more fully described an incorporated herein by reference in one or more of the following copending patent applications: (1) Ser. No. 08/234,100 filed April 28, 1994 and entitled "Self-Aligned Via Using Low Permittivity Dielectric"; (2) Ser. No. 08/286,761 filed August 5, 1994 entitled "Porous Dielectric Layer With a Passivation Layer for Electronics Applications"; (3) Ser. No. 08/294,290 filed August 23, 1994 entitled "Self-Aligned Contact Using Organic Dielectric Materials"; (4) Ser. No. 08/246,432 filed May 20, 1994 entitled "Interconnect Structure with an Integrated Low Density Dielectric"; and (5) Ser. No. 08/333,015 filed November 1, 1994 entitled "Pillars For Improved Damascene Conductor Fabrication".

### BRIEF DESCRIPTION OF THE DRAWINGS

These and other features of the invention will be apparent to those skilled in the art from a reading of the following detailed description of the invention, taken together with the accompanying drawings, in which:

The novel features and objects of the present invention will be apparent from a reading of the accompanying specification when read in conjunction with the accompanying drawings, in which:
Figs. 1A and 1B represent schematic illustrations of the cavity filling process of the present invention;
Fig. 2 represents a schematic illustration of an Enhanced Transfer Mobility (''ETM'') system that is used in practice of the present invention;
Fig. 3 is a schematic illustration of an ETM module;
Fig. 4 is a graphic illustration of process pressure and temperature on the fill capability of 0.5 micron 3:1 aspect ratio apertures;
Fig. 5 is a graphic illustration depicting sheet resistance following processing through different aperture schemes;
Figs. 6A and 6B are scanning electron microscope (SEM) cross-section micrographs of filled high aspect ratio apertures;
Figs. 7A and 7B are graphic illustrations of contact resistance and junction leakage forTi/TiN/ETM Aluminum plug process in accordance with the present invention;
Figs. 8A and 8B are graphic illustrations of Via resistance for a Tungsten (W) plug, Conventional Reflow, and Novel Aluminum Plug in accordance with the present invention;
Figs. 9A and 9B are graphic illustrations of Via chain yield comparisons for a Tungsten (W) plug, Conventional Reflow, and Novel Aluminum Plug in accordance with the present invention;
Figs. 10A and 10B are graphic illustrations of electromigration lifetime distributions for Tungsten and Aluminum plug Vias (10A) and metal leads (10B) formed by two sputter processes; and
Figs 11 and 12 illustrate gap filling in different substrates in accordance with the teachings of the present invention.

### DETAILED DESCRIPTION OF THE PREFERRED EMBODIMENTS

It is to be understood and appreciated that the process steps and structures described below do not form a complete process flow for the manufacture of integrated circuits. The present invention can be practiced in conjunction with integrated circuit fabrication techniques that are currently used in the art, and only so much of the commonly practiced process steps are included herein as are necessary to provide an understanding of the present invention. The drawing figures that are included with this specification and which represent cross-sections of portions of an integrated circuit during fabrication are not drawn to scale, but instead are drawn so as to illustrate the relevant features of the invention.

Aluminum reflow for contact/via filling in 0.5 mm applications has been previously demonstrated. However, aluminum reflow processes have not been widely accepted due to the higher deposition temperatures required and the difficulty in globally filling the high aspect ratio contacts and vias of ULSI circuits. Global filling is of particular concern for sub-0.5 mm applications, since a viable aluminum reflow technology must be capable of achieving equivalent or better yield and reliability as compared to conventional tungsten plug technology. The processes of the present invention demonstrate that enhanced aluminum fill at temperatures less than 450°C is indeed a viable process for sub-0.5 mm applications.

The advantages of an aluminum fill technology compared with integrated W-plug/aluminum leads include lower resistance contacts/vias, fewer overall process steps and improved electromigration performance. One of the principal disadvantages of conventional aluminum reflow processes has been their sensitivity of reflow to surface conditions and hole profile. Conventional hot sputter deposition and/or reflow processes rely on the diffusive mobility of the adatoms. Higher contact/via aspect ratios and the typical protrusion of sputtered barrier layers at the hole entrance adversely affect reflow characteristics. As a consequence, global filling has been difficult to achieve on a regular, reproducible basis.

The present invention provides, among other things, a global aluminum aperture fill technology that is capable of achieving complete filling of high aspect ratio sub-0.5 mm apertures at temperatures less than 450^{°}C. The aluminum aperture filling process is complemented by a high throughput T/TiN barrier metal deposition technique that does not use a physical collimator. Yield data from large-scale via chains can be used as a metric to compare the traditional integrated W-plug/aluminum leads, conventional aluminum reflow and the enhanced aluminum fill process. Identical Al-Cu alloys were used for each case. Electromigration reliability data for metal leads and vias is also presented comparing the new process with conventional methods.

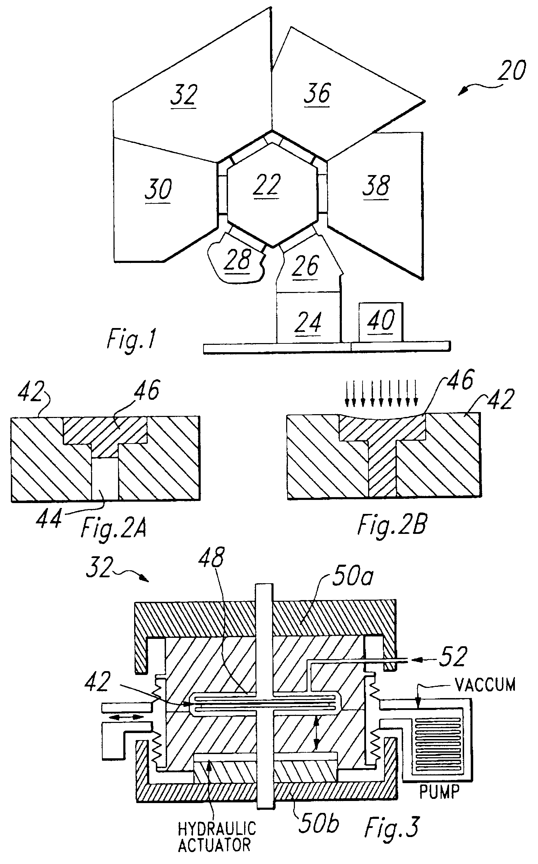

With reference to the drawings, wherein like reference characters represent like components throughout the various figures , and with particular reference to Fig. 1, there is depicted an enhanced transfer mobility ("ETM") system designated generally by reference numeral 20, such as the Sigma ETM System manufactured by Electrotech Ltd. of Bristol, U.K. The ETM system 20 is provided with a generally hexagonal configuration. The device 20 includes a cassette handler 22 that conveys one or more cassettes (not shown) from a cassette loading zone 24 through a pressure variable loading dock 26 that is operable to cycle between different levels of vacuum as the cassettes are transported between different process chambers in the manner to be described below. The cassette handler is configured as a rotatable, extendable arm that is operable to transfer wafers from cassettes to the process chambers and back to a cassette as the wafers are processed by the device. Cassettes are initially transported by the handler 22 to a heating station 28 for preliminary thermal processing. Once the wafers have attained a prescribed temperature, they are transported by the handler 22 to a physical vapor deposition ("PVD") station 30 for the deposition of suitable metallic materials, such as aluminum, aluminum alloys, copper, copper alloys and other suitable materials. Following PVD station treatment, the wafers are transported by handler 22 to the ETM station 32 for high pressure/temperature processing in a manner to be described below. Following completion of ETM processing, the wafers are transported to a high-power physical vapor deposition ("PVD") chamber 36 where they are treated with Titanium and/or Tin. Upon completion of Ti/TiN physical vapor deposition, the wafers are transported by the handler 22 to chamber 38, where they undergo a soft sputter etch. Etch chamber 38 can optionally include a heating station (not shown) to facilitate thermal processing of the wafers during etching. The sputter etch is a relatively low energy process at approximately 100 volts. A monitor 40 is connected t various control apparatus to provide a display of the progress of wafers through the device 20.

Silicon wafers 42 were processed through a 0.35 mm CMOS Double-Level-Metal (DLM) flow (not shown) that utilized chemical mechanical planarization of the poly-metal-dielectric (PMD) and interlevel-metal-dielectric (IMD). Contacts and vias 44 were patterned using phase shifted I-line lithography followed by plasma etch. A Ti/TiN barrier was sputter deposited by a collimator-less process that provided improved step coverage at the bottom of high aspect ratio holes. This improvement in step coverage was achieved by increasing the target-to-substrate distance. The advantages to this approach include higher throughput and fewer particles, since no physical collimator is interposed in the deposition path. The aluminum hole filling was achieved via a two step process. Conventional sputter deposition of an Al-Cu alloy 46 at about 400^{°}C was used to bridge the top of each hole with metal, leaving a void inside the hole as seen in the schematic of Figure 2A. The wafer 42 was then transferred under vacuum to the ETM (Enhanced Transfer Mobility) as is more fully illustrated in Fig. 3,of an ETM system 20 (Fig. 1). The ETM module 32 consists of a high pressure chamber 48 with two radiant 50a and 50b heaters for precise control of wafer temperature. The bridged Al-Cu was then forced into the holes 44 by pressurizing the chamber 48 with argon delivered through inlet 52. Typical operating pressures and temperatures were 60 MPa and 400^{°}C, respectively. Complete hole filling ocurred as a result of extrusion of the Al-Cu alloy into the hole (Figure 2B) due to the external pressure.

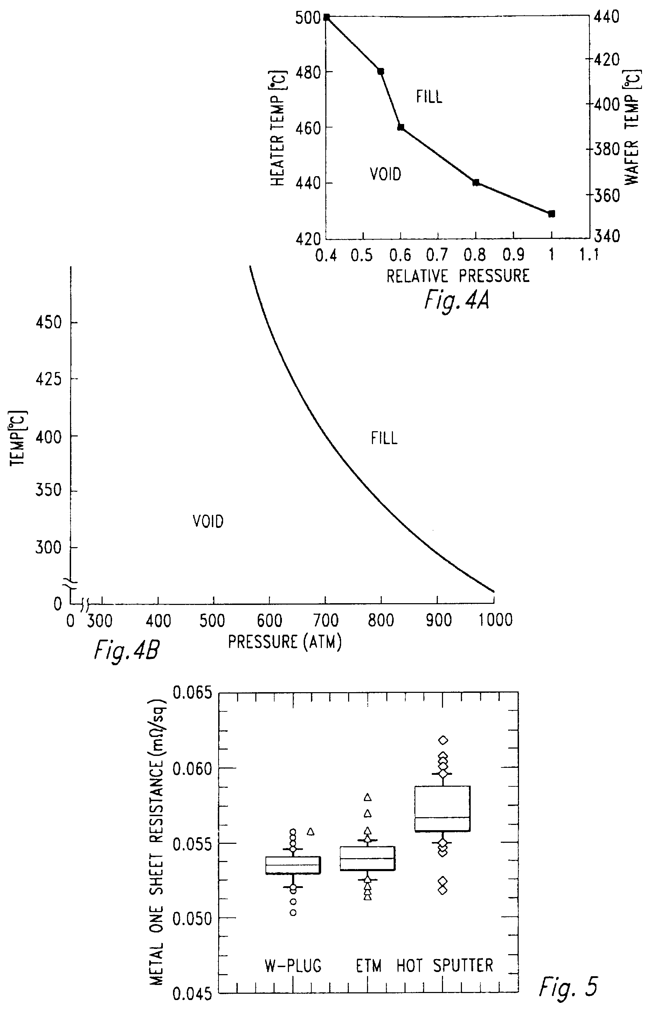

Figures 4A and 4B summarize the effect of pressure and temperature on the fill capability of this technique. Fig. 4B graphically illustrates the extent of aperture or hole fill as a function of both wafer temperature (^{o}C) and atmospheric pressure. The preferred range of temperatures and pressures in accordance with the present invention are temperatures of about 250^{o}C-450^{o}C, atmosphere pressures of about 300-1,000 atmospheres (atm), at vacuum pressures of about 10⁻⁶ - 10⁻⁸ Torr. Control samples were also processed using a conventional etchback W-plug approach as well as a conventional high temperature (525^{°}C) aluminum reflow process. In all cases, a TiN capping layer was sputter deposited on top of the aluminum prior to pattern and plasma etch of the second leads. Lastly, the wafers were passivated using a plasma-deposited oxide/nitride bilayer.

### RESULTS AND DISCUSSION

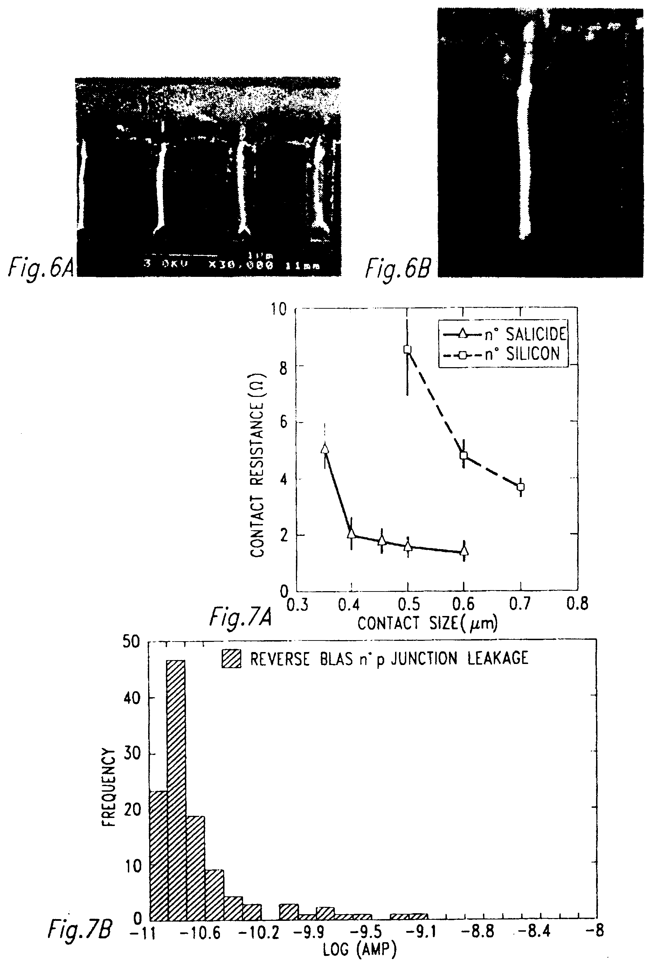

Figures 5A and 5B illustrate SEM cross sections of high aspect ratio holes fabricated by the enhanced aluminum fill technique of the present invention. Complete filling was achieved even for the smallest hole size of 0.25 mm and filling was not encumbered by the barrier film protrusion. In order to estimate the maximum wafer temperature during the entire hole filling sequence, the sheet resistance of the underlying level of metal was measured following the aluminum hole fill processing at the second level. Figure 6 shows a plot of metal one sheet resistance distributions for wafers processed with the standard W-plug process, the ETM Al-fill process of the present invention and conventional hot sputtered aluminum. The differences in the sheet resistance are a result of the thermally activated reaction between the TiN/Al-alloy layers of the metal stack. The high wafer temperature of conventional hot sputtered aluminum is evident from this plot while the W-plug and ETM processed wafers show similar sheet resistances, confirming the low (∼400^{°}C) temperature of the novel aluminum fill process.

Figures 7A and 7B illustrate contact resistances and junction leakage characteristics, respectively, for the ETM Al-plug technology of the present invention. Good contact resistance and junction characteristics were realized using Ti/TiN barrier and the novel Al-plug scheme compared to the standard W-plug approach. Large contact chains fabricated using the novel Al-plug also showed better yields compared to W-plug process.

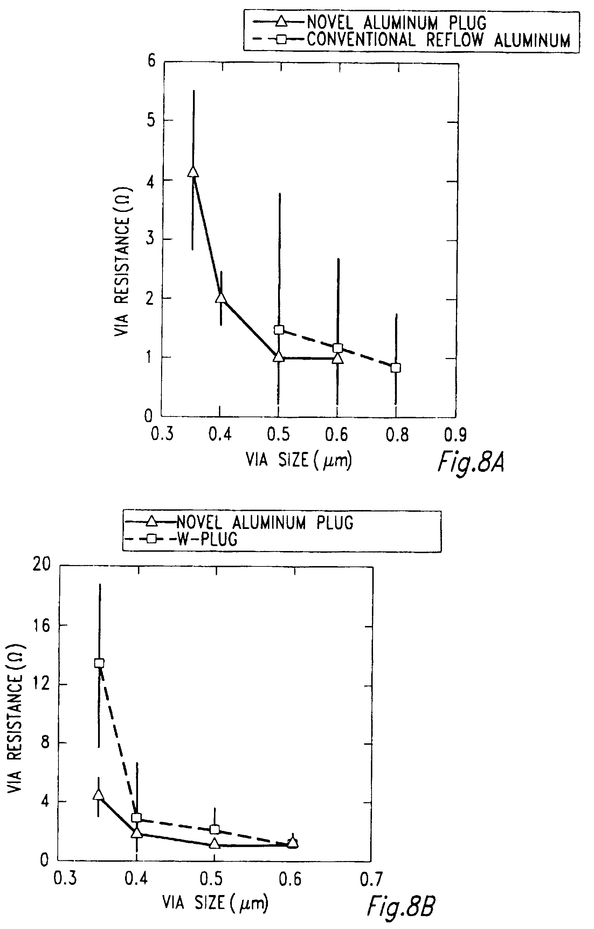

Figures 8A and 8B compare the via resistances of plugs formed by tungsten deposition/etchback and or conventional aluminum reflow with plugs formed by the enhanced aluminum fill process of the present invention. For both cases, the enhanced Al fill process results in much tighter via resistance distributions, even for hole sizes as small as 0.25 mm. Failure analysis indicates that incomplete filling contributed to the wider via resistance distribution observed for the case of conventional aluminum reflow, whereas variations in interfaces and nucleation layers are thought to cause the wider distributions observed for tungsten plugs.

As contact and via sizes decrease, there is less resistance margin (hence process margin) for tungsten compared with aluminum due to its inherently higher resistivity. The observed variations in via resistance directly translate into parametric yield loss. While via resistance specifications may be relaxed to compensate for process shortcomings, resultant circuit designs will suffer in performance. Thus, it is important to minimize via resistance as technologies scale.

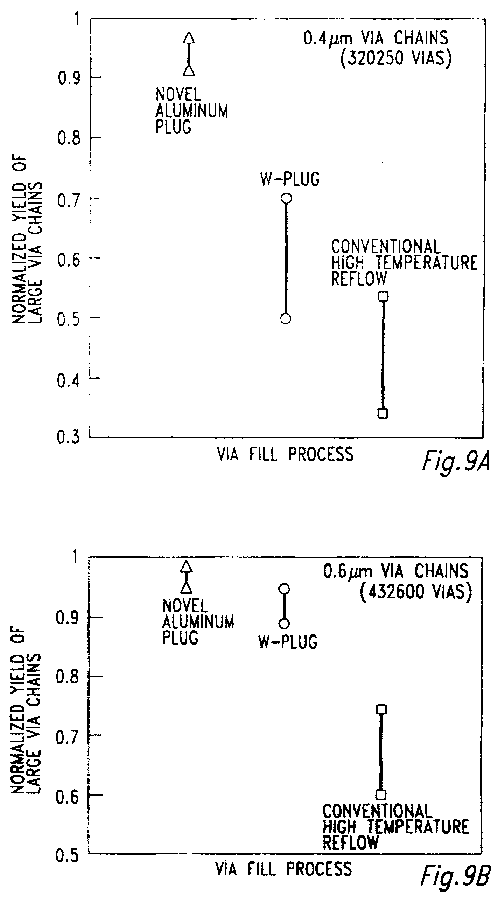

Figures 9A and 9B the yields of large via chains for 0.6 mm and 0.4 mm via sizes. For 0.6 mm vias, the W-plug and enhanced fill process were found to have comparable yield, but the conventional reflow process yielded poorly. At 0.4 mm, the enhanced Al fill process gave consistently higher via chain yield than both the W-plug and conventional reflow processes.

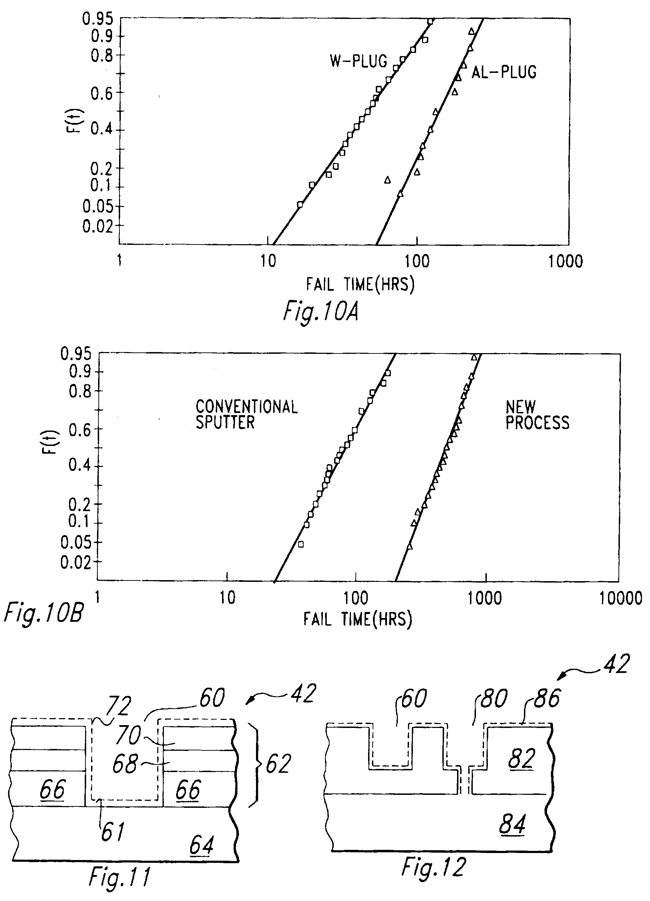

Excellent metal lead and via reliability (Figure 10A and 10B) were also realized for the enhanced fill process as compared with conventional lower temperature (300^{°}C) aluminum metallization and W-plugged vias respectively. The superior reliability of the aluminum filled vias is believed to be due to a reduction in current crowding, since an Al-plug offers both lower resistivity and fewer resistive interfaces as compared with conventional W-plug structures. The improved lead performance is primarily due to the larger grain size of the metal for the aluminum plug process.

In a further aspect of the invention, as illustrated in Fig. 11, a via 60 is provided having an outer surface 61 that is formed in the body of a multilayer dielectric 62 that overlies a metal layer 64 that has been formed in the semiconductor wafer. The dielectric 62 can be provided with a multitude of overlying layers, of which three layers 66, 68 and 70 are depicted. For example, the lowermost dielectric layer 66 can comprise a plasma oxide, over which can be deposited a layer 68 of silsesquioxane. A plasma tetraethyloxysilane layer 70 can be deposited over the intermediary layer 68 to form the upper surface of the dielectric. The foregoing multi-level dielectric is for illustrative purposes, for which departures can be made as to one or both the number of levels and level composition without departing from the teachings of the present invention. A suitable liner 72 can optionally be provided along the interior surface of the via 60, as illustrated in phantom in the drawing. The liner 66 can be formed in a conventional manner, as by Ti, TiN, or a combination thereof that is applied to the via surface 61 by PVD or CVD processes.

In a further aspect of the invention, as illustrated in Fig. 12, there is depicted a semiconductor body having a via 60 and trench 80 that are formed in a single or multilayer dielectric body 82. The via 60 extends partially through the dielectric 82, whereas the trench 80 extends completely through the dielectric 82 to the underlying metal layer 84 to provide for electrical connection to the metal surface 84. A liner 86 can optionally be provided along the inner surface of the via and trench as discussed previously. Aluminum or a suitable aluminum alloy or other metal/metal alloy as discussed above can be introduced into the via 60 and trench 80, the compressed/deformed under superatmospheric pressure up to about 1000 ATM so as to cause deformation of the applied metal to fill the via and trench. Superatmospheric pressure effects via/trench opening has been obstructed by metal particles prior to complete filling of the via/trench, as the applied pressure extrudes or otherwise directs the applied material into the via/trench to effect via/trench filling.

### CONCLUSIONS

A high-yielding aluminum plug process has been demonstrated for global filling of high aspect ratio (>4:1) contacts and vias as small as 0.25 mm at relatively moderate process temperature (<450^{°}C). Compared with conventional W-plug/aluminum leads, the aluminum plug process also exhibits an order of magnitude improvement in reliability. These results establish the viability of enhanced aluminum fill as a sub-0.5 mm manufacturing technology.

Although the present invention and its advantages have been described in connection with the preferred embodiments, it should be understood that various changes, substitutions and alterations can be made herein without departing from the spirit and scope of the invention as defined by the appended claims.

## Claims

1. A process for filling a semiconductor aperture, comprising the stepS of:
providing a semiconductor body having a surface and at least one aperture which extends at least partially into said body and away from said surface, said aperture having an open end;
applying a metal to said aperture open end;
heating said wafer to a temperature of between about 250^{o}C and about 450^{o}C; and
applying pressure to said metal to deform said metal and to direct said metal into said aperture to substantially fill said aperture with said metal while said semiconductor body is maintained at a temperature of between about 250°C and about 450°C.

2. The process according to claim 1, wherein said pressure is applied in the rang of about 300 - 1,000 atmospheres.

3. The process according to claim 1, wherein said metal is applied in a vacuum of between about 10⁻⁶ and 10⁻⁸ Torr.

4. The process according to claim1, wherein said metal is slected from a group consisting essentially of one or more of the following compositions: (1) Al-Ti (0.1%) - Cu (0.5%); (2) Al - Cu (0.5%); (3) Al - Cu (1%); (4) Al - Si (1%) - Cu (0.5%); (5) Aluminum; (6) Copper; (7) alloys of Cu with one or more of the follwing metals: (I) Mg, (ii) Au, and (iii) Ag; (8) Al - Sc - Cu; (9) Ti; (10) TiN; and (11) combinations of Ti with one or more of the following: TiN, TiW and W.

5. The process according to claim 1, wherein said aperture is formed in a semiconductor body having a polymeric insulator.

6. The process according to claim 5, wherein said polymeric insulator consists essentially of any one or more of the family of polytetrafluoroethylene (''PTFE'') compounds; polymeric spin-on-glass (''SOG'') compounds; parylene; polyimides; hydrongen silsesquioxane; and aerogels and surface modified aerogels.

7. The process according to claim 6, wherein said polymeric insulator is configured as a stack having at least two discrete levels, said levels consisting essentially of different ones of said recited polymeric insulators.

8. The process according to claim 5, wherein said aperture provided with a metal liner that is applied aby one of a chemical vapor or physical vapor deposition process.

9. The process according to claim 8, wherein said aperture is inthe form of a via so as to extend from an upper level of metal through a dielectric to a lower level of metal.

10. The process according to claim 1, wherein said aperture is in the form of a trench.

11. The process according to claim 1, further comprising the step of applying a metal liner in said aperture prior to the application of metal to said aperture.

12. The process according to claim 1, further comprising the step of outgassing contaminants from said aperture prior to the application of metal to said aperture.

13. The process according to claim 1, furhter comprising the step of applying a dielectric liner to said aperture prior to the application of metal to said aperture.

14. The process according to claim 1, wherein said pressure is applied while said semiconductor body surface is exposed to an atmosphere containing an inert element.

15. The process according to claim 1, wherein said aperture is formed in a dielectric material and is provided with a metal liner that is applied by one of a chenical vapor or physical vapor deposition process.

16. The process according to claim 1, wherein said aperture is formed in the absence of an oxide sidewall.

17. The process according to claim 1, further comprising the step of positioning said semiconductor body in a pressurizeable chamber and applying fluid pressure to said applied metal to drive said metal into said aperture.

18. A Process according to any preceding claim wherein the aperture is a trench or a via.

19. A process according to claim 5 and wherein said innsulator extends at least partially into said aperture.

20. A process according to claim 13 and wherein said dielectric extends a t least partially into said aperture.

21. A silicon body having a aperture filled by the method of any preceding claim.

22. An integrated circuit including a silicon body as claimed in claim 21.
